# EUROPEAN PATENT APPLICATION

(11) **EP 2 312 643 A2**
(43) Date of publication of application: **20.04.2011**
(21) Application number: 10007316.2
(22) Date of filing: 14.07.2010
(51) Int. Cl.: H01L 31/0236, H01L 31/18

(54) **Surface structure of crystalline silicon solar cell and manufacturing method thereof**

(30) Priority: 16.10.2009 TW 98135197
(71) Applicant: Motech Industries Inc., Shen-Keng Taipei Hsien (TW)
(72) Inventor: Lin, Mien-Liang, Yongkang City Tainan County 710 (TW); Lin, Ching-Ying, Tainan City 700 (TW); Tu, Ching-Hao, Tainan City 701 (TW)
(74) Representative: Epping - Hermann - Fischer

(57) **Abstract**

The present invention provides a surface structure of a crystalline silicon solar cell and a manufacturing method thereof. The surface structure of the crystalline silicon solar cell comprises a main body having a front side microstructure and a back side microstructure. A surface morphology of the front side microstructure includes a plurality of cone structures, a surface morphology of the back side microstructure includes a plurality of arc structures, and a surface roughness of the front side microstructure is greater than that of the back side structure.

## Description

### Background of the Invention

### [Field of the Invention]

The present invention is related to a crystalline silicon solar cell, more particularly, to a surface structure of a crystalline silicon solar cell having a surface roughness of the front side microstructure greater than that of the back side microstructure.

### [Description of the Prior Art] I

Recently, under the atmosphere of environmental protection and pursuit of energy saving and carbon reduction, green power is promoted to be a replacement of oil. Therefore, the solar energy industry has a vigorous development due to the market demand. One example is the increasing demand for solar cells.

One of the most important factors for evaluation of solar cells is photoelectric conversion efficiency. In the prior art, the microstructure on the surface of a solar cell is typically formed by acid or alkaline etching process and has a high surface roughness. Besides, the thickness of the solar cell is largely reduced by the acid or alkaline etching, which makes it easy to crack during the process. The worst of all, the solar cells manufactured by the traditional process have low photoelectric conversion efficiency. Therefore, it is necessary to increase the photoelectric conversion efficiency.

### Summary of the Invention

The object of the present invention is to provide a surface structure of a crystalline silicon solar cell having a front side microstructure with a surface roughness greater than that on the back side, which enhances the photoelectric conversion efficiency and lowers probability of cracking during the manufacturing process.

The present invention provides a surface structure of a crystalline silicon solar cell and a manufacturing method thereof. The surface structure of the crystalline silicon solar cell includes a main body having a front side microstructure and a back side microstructure, wherein a surface morphology of the front side microstructure comprises a plurality of cone structures, a surface morphology of the back side microstructure comprises a plurality of arc structures, and a surface roughness of the front side microstructure is greater than that of the back side structure.

According to one embodiment of the present invention, the main body the crystalline silicon solar cell further includes an anti-reflective coating layer, a N type emitter and a P type emitter, wherein the N type emitter is disposed on the P type emitter and the anti-reflective coating layer is disposed on the N type emitter.

The present invention also provides a method of manufacturing a surface structure of a crystalline silicon solar cell having a main body with a front side and a back side. The method includes the steps of etching the main body on the front side and a back side by a KOH solution or a mixture of HN0₃ and HF, covering the back side of the main body by a protecting material, and etching the main body on the front side by SF6 or a mixture of IPA and KOH, and removing the protecting material from the back side.

Thus, the surface structure of the crystalline silicon solar cell according to present invention has one or more of the following advantages:
(1) Since the surface roughness of the microstructure on the back side of the solar cell is smaller than that of the microstructure on the front side, the surface of the back side is flatter than the front side.
(2) The surface morphologies of the microstructures of the crystalline silicon solar cell enhance the photoelectric conversion efficiency.
(3) The surface morphologies of the microstructures of the crystalline silicon solar cell efficiently lower the probability of cracking during the manufacturing process.

### Brief Description of Drawings

- Fig.1 is: a diagram showing a surface structure of a crystalline silicon solar cell according to one embodiment of the present invention.
- Fig.2 is: a diagram showing a surface structure of a crystalline silicon solar cell according to another embodiment of the present invention.
- Fig.3 is: an SEM photo showing a surface morphology of the front side microstructure in the main body according to one embodiment of the invention.
- Fig.4 is: an SEM photo showing a surface morphology of the back side microstructure in the main body according to one embodiment of the invention.
- Fig.5 is: an SEM photo showing a surface morphology of the front side microstructure in the main body according to another embodiment of the invention.
- Fig.6 is: a flowchart showing a manufacturing process of a surface structure of a crystalline silicon solar cell according to one embodiment of the invention.
- Fig.7 is: a chart showing the photoelectric conversion efficiency of the surface structure of the crystalline solar cell manufactured on a 6-inch silicon wafer according to one embodiment of the invention.
- Fig.8 is: a chart showing the photoelectric conversion efficiency of the surface structure of the crystalline solar cell manufactured on a 5-inch silicon wafer according to one embodiment of the invention.

### Detailed Description of Preferred Embodiments

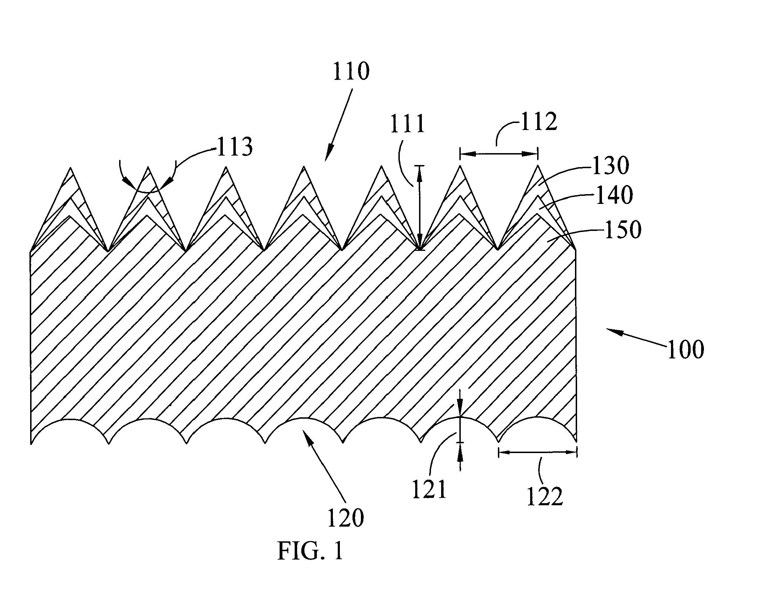

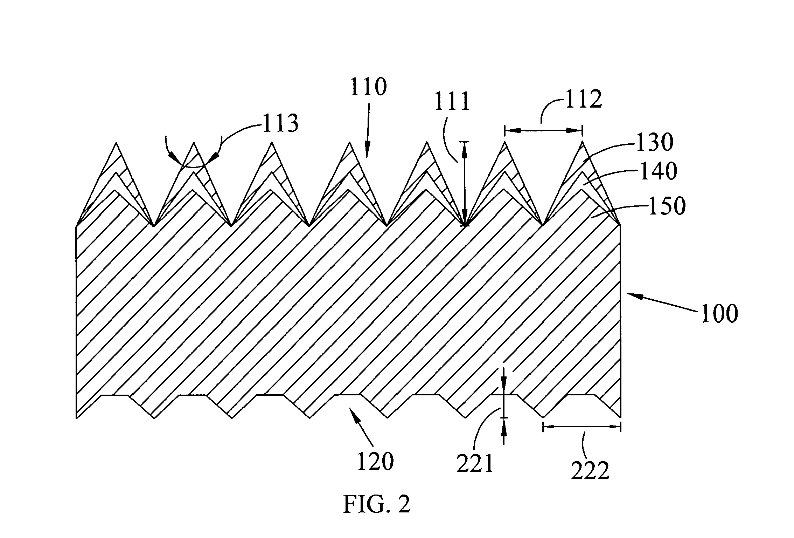

Fig.1 and Fig.2 are diagrams showing surface structures of crystalline silicon solar cells according to two different embodiments of the present invention. In Fig. 1, the surface structure of the silicon solar cell includes a main body 100 having a front side microstructure 110 and a back side microstructure 120. The surface roughness of the front side microstructure 110 is greater than that of the back side microstructure 120. The surface morphology of the front side microstructure 110 has cone structures with vertexes away from the main body 100 while the surface morphology of the back side microstructure 120 has arc structures. In Fig.2, the surface morphology of the back side microstructure 120 has polygon structures rather than arc structures.

In Fig. 1, the heights 111 of the cone structures of the surface morphology of the front side microstructure 110 are larger than or equal to 0.1 *µ*m, and lower than or equal to 30 µm, while intervals 112 between the vertexes of the cone structures are longer than or equal to 0.1 µm, and shorter than or equal to 30µm. Angles 113 of the vertexes of the cone structures are larger than or equal to 1°_{,} and smaller than or equal to 89_{°}. Widths 122 and depths 121 of the arc structures of the surface morphology of the back side microstructure 120 are larger than or equal to 0.1µm, and smaller than or equal to 15 µm. In Fig.2, the polygon structures may be trapezoids, each having a height 221 larger than or equal to 0.1 µm, and smaller than or equal to 30µm, and having a bottom parallel side with a length 222 longer than or equal to 0.1 µm, and smaller than or equal to 30µm.

The main body 100 of the surface structure of the crystalline silicon solar cell further includes an anti-reflective coating layer 130, a N type emitter 140 and a P type emitter 150, wherein the N type emitter 140 is disposed on the P type emitter 150 and the anti-reflective coating layer 130 is disposed on the N type emitter 140.

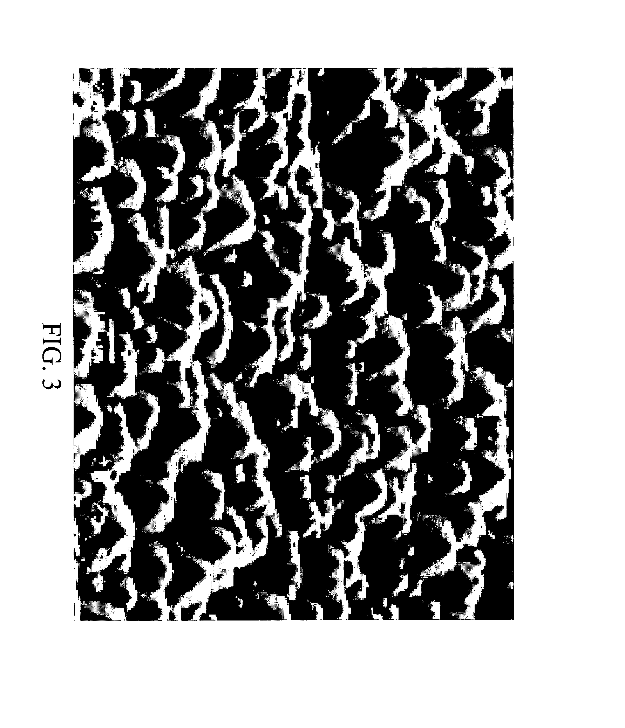

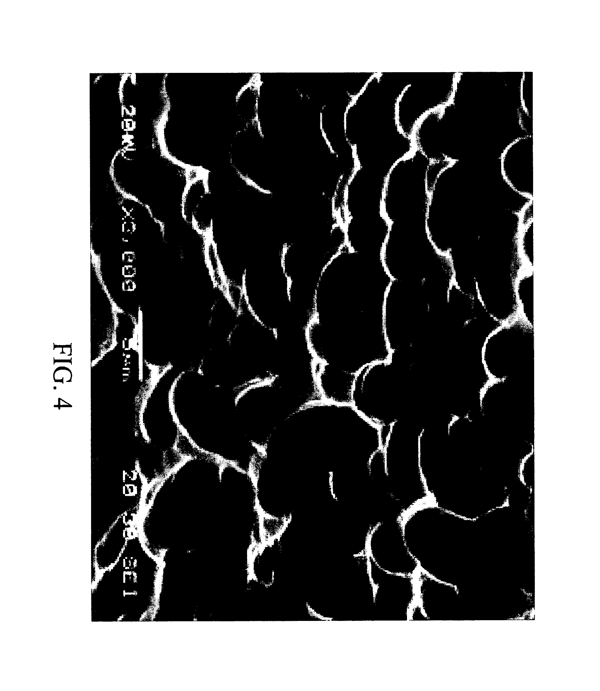

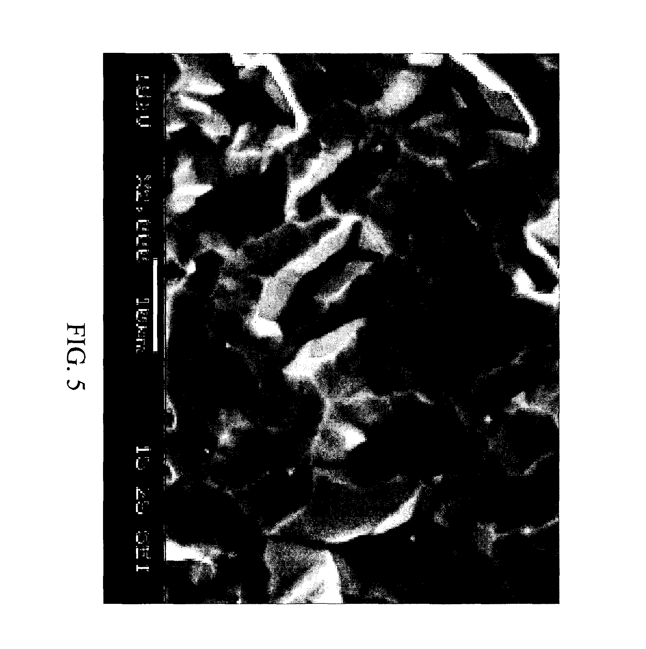

Fig.3, 4 and 5 are SEM photos taken from the front or back side of the crystalline silicon solar cell according to embodiments of the invention. Fig.3 is a 11000X SEM photo taken from the front side microstructure, which shows many cone structures on the surface of the front side microstructure. Although the circular cone structures are shown in Fig.3, pyramid-like cone structures are more preferable. Fig.4 is a 3000X SEM photo taken from the back side microstructure, which shows many arc structures on the surface of the back side microstructure. Fig.5 is a 2000X SEM photo taken from the back side microstructure of the crystalline solar cell according to another embodiment of the invention, which shows many trapezoids on the surface of the back side microstructure.

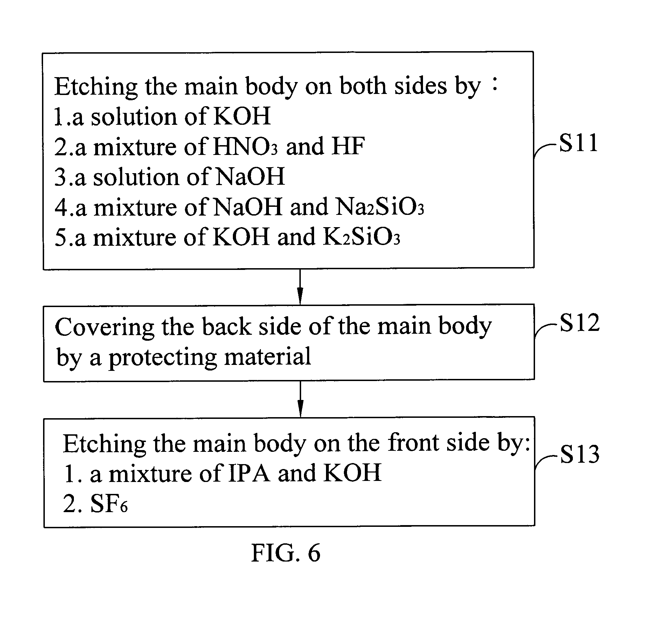

Fig. 6 is a flowchart showing a manufacturing process of a surface structure of a crystalline silicon solar cell according to one embodiment of the invention. The surface structure of the crystalline silicon solar cell has a main body with front and back sides.

In step S11, the main body is etched on both of the front and back sides by a first etching material. The first etching material is a solution of KOH or a mixture of HN0₃ and HF. The following may be also used as the first etching material: (1) a solution of NaOH, (2) a mixture of NaOH and Na₂Si0₃, or (3) a mixture of KOH and K₂Si0₃. If the mixture of HN0₃ and HF is used as the etching material, H₂S0₄, H₂C₂0₄, CH₃COOH, H₂0₂, H₃P0₄ or a combination thereof may be added.

In step S12, the back side of the main body is covered by a protecting material against the etching in the following step S 13.

In step S 13, the main body is etched by a second etching material. The main body is etched only on the front side since its back side has been covered by the protecting material in STEP S12. The second etching material is SF6 or a mixture of IPA and KOH. The following may be also used as the second etching material: (1)a mixture of IPA, KOH and K₂Si0₃, (2) a mixture of IPA and NaOH, or (3) a mixture of IPA, NaOH and Na₂Si0₃. Then, the protecting material is also removed from the back side. The second etching step is a dry etching if SF6 is used as the second etching material.

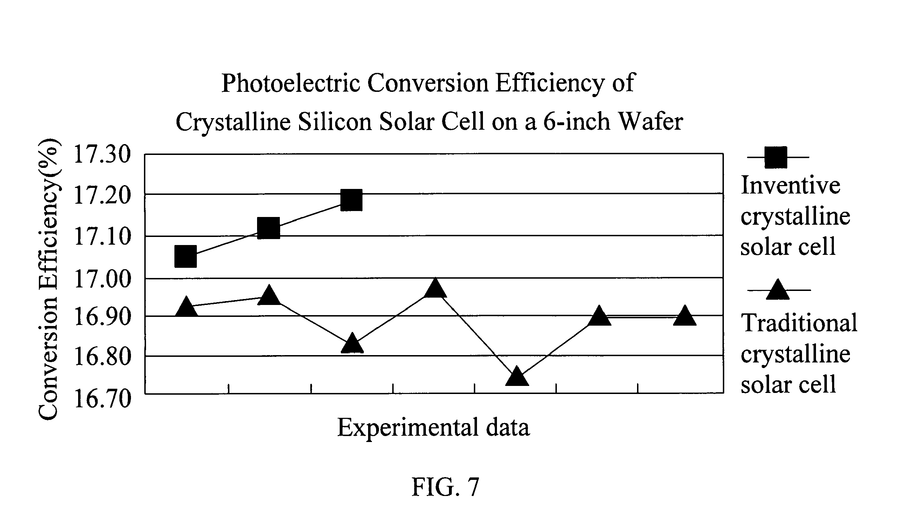

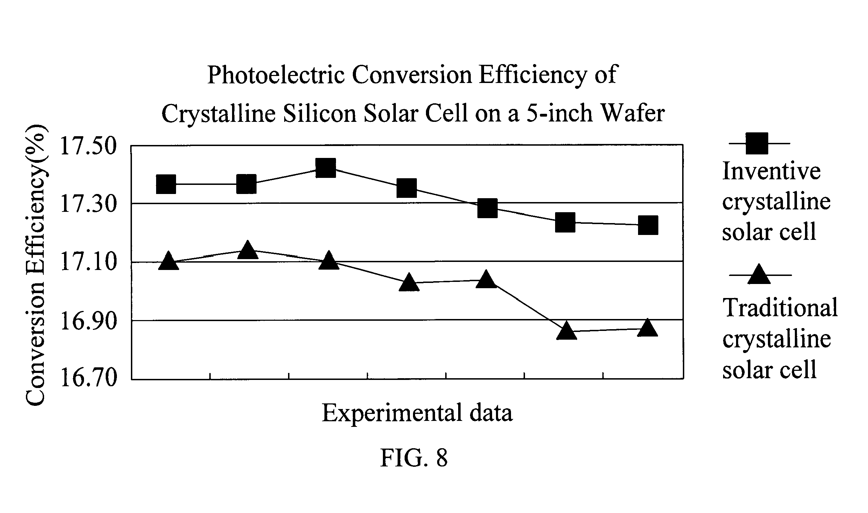

Fig.7 and 8 respectively show the photoelectric conversion efficiency of the surface structure of the crystalline silicon solar cells manufactured on a 6-inch and 5-inch silicon wafer according to embodiments of the invention. It is noted that, in Fig.7, the mean photoelectric conversion efficiency of a traditional surface structure of the crystalline solar cell is 16.88% while that of the present invention is 17.12%. The photoelectric conversion efficiency is increased by 1.4%. In Fig.8, the photoelectric conversion efficiency of the surface structure of the crystalline solar cell of the present invention even has a higher value of 17.31 %. They prove that the present invention enhances the photoelectric conversion efficiency.

## Claims

1. A surface structure of a crystalline silicon solar cell, **characterized in that**:
a main body having a front side microstructure and a back side microstructure,
wherein a surface morphology of the front side microstructure comprises a plurality of cone structures, a surface morphology of the back side microstructure comprises a plurality of arc structures or polygon structures , and a surface roughness of the front side microstructure is greater than that of the back side structure.

2. The surface structure of the crystalline silicon solar cell as claimed in claim 1, **characterized in that** the heights of the cone structures are larger than or equal to 0.1 µm, and lower than or equal to 30µm, while intervals between vertexes of the cone structures are longer than or equal to 0.1 µm, and shorter than or equal to 30µm, angles of the vertexes of the cone structures are larger than or equal to 1, and smaller than or equal to 89_{°}.

3. The surface structure of the silicon solar cell as claimed in claim 1, **characterized in that** widths and depths of the arc structures are larger than or equal to 0.1 µm, and smaller than or equal to 15 µm.

4. The surface structure of the crystalline silicon solar cell as claimed in claim 1, **characterized in that** the polygon structures are trapezoids, each having a height larger than or equal to 0.1 µm, and smaller than or equal to 30µm, and having a bottom parallel side with a length longer than or equal to 0.1 µm, and smaller than or equal to 30µm.

5. A method of manufacturing a surface structure of a crystalline silicon solar cell having a main body with a front side and a back side, the method, **characterized in that**:
etching the main body by a first etching material on the front side and the back side;
covering the back side of the main body by a protecting material; and
etching the main body by a second etching material on the front side;
wherein a surface roughness of microstructure on the front side is greater than that of the microstructure on the back side.

6. The method of manufacturing the surface structure of the crystalline silicon solar cell as claimed in claim 5, **characterized in that** the protecting material is removed from the back side when the main body is etched by the second etching material on the front side.

7. The method of manufacturing the surface structure of the crystalline silicon solar cell as claimed in claim 5, **characterized in that** the first etching material is KOH, HN0₃ and HF.

8. The method of manufacturing the surface structure of the crystalline silicon solar cell as claimed in claim 5, **characterized in that** the second etching step is a dry etching process using SF₆ as the second etching material.

9. The method of manufacturing the surface structure of the crystalline silicon solar cell as claimed in claim 5, **characterized in that** the second etching material is a mixture of IPA and KOH.
